# EUROPEAN PATENT SPECIFICATION

(11) **EP 0 744 885 B1**
(45) Date of publication and mention of the grant of the patent: **23.09.1998**
(21) Application number: 96108190.8
(22) Date of filing: 22.05.1996
(51) Int. Cl.: H05K 3/46, H02G 5/00, H01R 4/00

(54) **Multilayer busbar construction**
Aufbau einer mehrlagigen Sammelschiene
Construction multicouches d'une barre omnibus

(30) Priority: 23.05.1995 JP 124001/95
(43) Date of publication of application: 27.11.1996
(73) Proprietor: SUMITOMO WIRING SYSTEMS, LTD., Yokkaichi City Mie 510 (JP)
(72) Inventor: Kobayashi,Makoto, c/o Sumitomo Wiring Syst.Ltd., Yokkaichi-City, Mie 510 (JP)
(74) Representative: Müller-Boré & Partner Patentanwälte

(56) References cited:
- EP-A- 0 624 904
- WO-A-88/02943
- GB-A- 2 115 213
- US-A- 4 237 606
- US-A- 5 284 548

## Description

The present invention relates to a layer construction comprising busbars and insulating plates, which is to be accommodated in an electrical connection box.

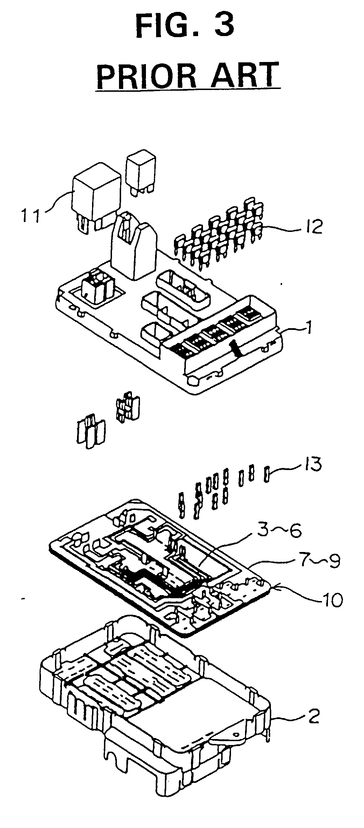

An electrical connection box used to connect wiring harnesses of an automotive vehicle is, as shown in FIG. 3, provided with upper and lower casings 1 and 2. A layered element 10 including busbars 3 to 6 for forming an internal circuit and insulating plates 7 to 9 are accommodated in a space defined by the casings 1 and 2. The busbars 3 to 6 are connected via intermediate terminals 13 with relays 11 and fuses 12 mounted in receptacles formed on the upper surface of the upper casing 1.

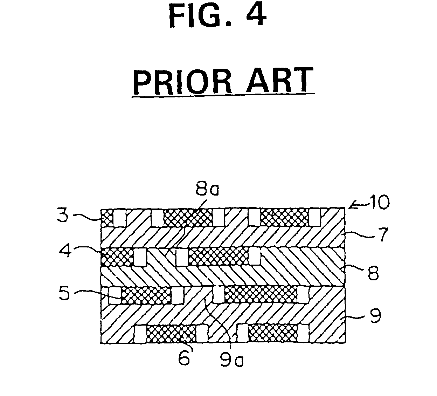

As shown in detail in FIG. 4, the layered element 10 is, for example, such that the first busbars 3 are arranged on the upper surface of the upper insulating plate 7, the second busbars 4 on the upper surface of the intermediate insulating plate 8, the third busbars 5 on the upper surface of the lower insulating plate 9, and the fourth busbars 6 on the lower surface of the lower insulating plate 9.

The lower surface of the upper insulating plate 7 and the lower surface of the intermediate insulating plate 8 are in contact with the upper surfaces of ribs 8a formed in the intermediate insulating plate 8 and the upper surfaces of ribs 9a formed in the lower insulating plate 9, respectively. Further, the lower surface of the upper insulating plate 7 and the lower surface of the intermediate insulating plate 8 are substantially in contact with the upper surfaces of the second busbars 4 and the upper surfaces of the third busbars 5, respectively.

However, the layered element 10 requires three insulating plates 7 to 9 to arrange four layers of busbars 3 to 6. This leads to an increased number of parts and an increased production cost for the layered element 10, and consequently to an increased weight of the electrical connection box.

In order to solve the above problem, an object of the present invention is to provide a layer construction of busbars and insulating plates which can be produced at a reduced cost by reducing the number of insulating plates and in particular contribute to make an electrical connection box more lightweight.

This object is solved according to the invention by a layer construction according to claim 1. Preferred embodiments of the invention are subject of the dependent claims.

According to the invention there is provided a layer construction to be accommodated in an electrical connection box, comprising at least two insulating plates for locating between opposing surfaces thereof at least two adjacent busbar-layers, each comprising at least one busbar, wherein spacing means which are integrally formed with at least one of the insulating plates provide for spacing areas by keeping the opposing surfaces in a distance in a direction substantially normal to the plane of the insulating plate which is greater than the combined thickness of the at least two busbar-layers.

According to a preferred embodiment of the invention, within the spacing areas the lower surfaces of busbars of one busbar-layer arranged on the lower surface of the upper insulating plate are opposed to and spaced apart from the upper surfaces of the busbars of the other busbar-layer arranged on the upper surface of the lower insulating plate.

Further preferably, the spacing means comprise clearance providing ribs projecting from the lower surface of the upper insulating plate and clearance providing ribs projecting from the upper surface of the lower insulating plate in the opposing direction and are preferably in contact with opposite busbars.

Further preferably, the spacing means providing spacing areas are arranged on each surface of adjacent insulating plates.

According to a further preferred embodiment, at least one busbar-layer having at least one busbar is arranged on a surface of an insulating plate not facing an adjacent insulating plate.

Preferably, the busbars are secured on the upper and lower surfaces of each insulating plate, wherein each formed with at least one through hole through which a fixing rib projecting from the corresponding insulating plate is insertable, respectively.

Further preferably, the busbars are secured with the corresponding insulating plates by deforming the leading end of the fixing ribs.

Preferably, both adjacent insulating plates are provided with spacing means each projecting toward the other insulating plate respectively.

According to a further preferred embodiment of the invention, the distance by which the insulating plates are spaced is greater than the combined or total thickness of three layers of busbars adjacent in the above normal direction.

Preferably, at least one spacing area comprises a stepped portion, wherein the stepped portion preferably supports a busbar of the intermediate busbar layer, preferably approximately midway.

According to a preferred embodiment of the invention, there is provided a layer construction of busbars and insulating plates to be accommodated in an electrical connection box, wherein the lower surface of a busbar arranged on the lower surface of an upper insulating plate is opposed to and spaced apart from the upper surface of a busbar arranged on the upper surface of a lower insulating plate by a specified distance without disposing an insulating plate therebetween, and wherein clearance providing ribs projecting from the lower surface of the upper insulating plate and the upper surface of the lower insulating plate in the opposing direction and are in contact with the opposite busbars.

In this layer construction, the lower surface of the busbar arranged on the lower surface of an upper insulating plate (corresponding to the second busbar) is opposed to and spaced apart from the upper surface of the busbar arranged on the upper surface of the lower insulating plate. Further, the clearance providing ribs projecting from the lower surface of the upper insulating plate and the upper surface of the lower insulating plate in the opposing direction are substantially in contact with the opposite busbars or the opposite surface of the opposite insulating plate. Accordingly, the respective busbars can be retained, spaced part from each other. Thus, the insulating plate disposed between the second and third busbars in the prior art layer construction can be dispensed with. In other words, if N denotes the number of layers of busbars and I denotes the number of insulating plates, equations I = N - 1 and I = N/2 can be established for the prior art and the invention, respectively. Therefore, when compared with the prior art, the number of insulating plates required for the invention can be reduced in proportion to the number of layers of busbars.

If the insulating plates and layers of busbars are alternately arranged from the bottommost layer, the insulating plates and the busbars are not necessarily required to be secured with each other. In such a case, the busbars arranged on the lower surface of the bottommost insulating plate may be held by the lower casing.

As is clear from the above, the lower surfaces of the busbars arranged on the lower surface of the upper insulating plate are opposed to and spaced apart from the upper surfaces of the busbars arranged on the upper surface of the lower insulating plate by the specified distance, and the ribs projecting from the insulating plates act to hold the spacing. Accordingly, the intermediate insulating plate can be dispensed with. Since the number of insulating plates can be reduced, thereby reducing the number of parts, the layer construction can be produced at a reduced cost, and the electrical connection box accommodating the busbars and the insulating plates can be made more lightweight.

The busbars may preferably be secured on the upper and lower surfaces of each insulating plate.

If the busbars are secured on the upper and lower surfaces of the insulating plates in advance, it is not necessary to hold the busbars arranged on the lower surface of the upper insulating plate by the clearance providing ribs projecting from the lower insulating plate. Accordingly, the busbars can be more securely held in their specified positions, compared with a case where they are held by the clearance providing ribs.

Furthermore, the busbars may be each formed with a through hole through which a fixing rib projecting from the corresponding insulating plate is inserted, and the busbars may be secured with the corresponding insulating plates by deforming the leading end of the fixing ribs.

This kind of securing of the busbars and the insulating plates can be easily performed only by deforming the leading ends of the fixing ribs, thereby ensuring satisfactory assembling.

These and other objects, features and advantages of the present invention will become more apparent upon a reading of the following detailed description and accompanying drawings in which:
FIG. 1(A) is a partial section of a layered element of busbars and insulating plates according to a first embodiment of the invention,
FIG. 1(B) is a partial section of a layered element of busbars and insulating plates according to a second embodiment of the invention,
FIG. 2(A) is an exploded partial perspective view of the layered element of FIG. 1(A),
FIG. 2(B) is a section showing a fixing rib,
FIG. 3 is an exploded perspective of an electrical connection box, and
FIG. 4 is a partial section of a prior art layered element.

Hereafter, the invention is described in detail with reference to the illustrated embodiments.

It should be appreciated that no description is given to elements having the same construction and operation as those of the prior art shown in FIGS. 3 and 4 by identifying them by the same reference numerals.

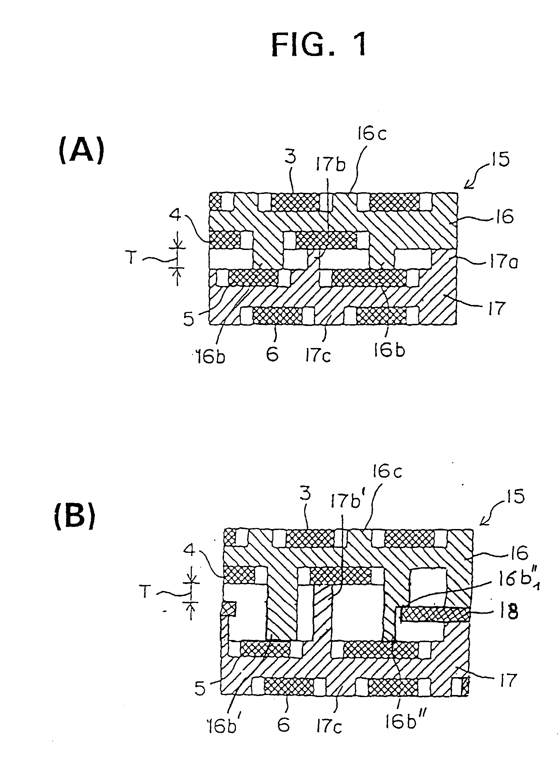

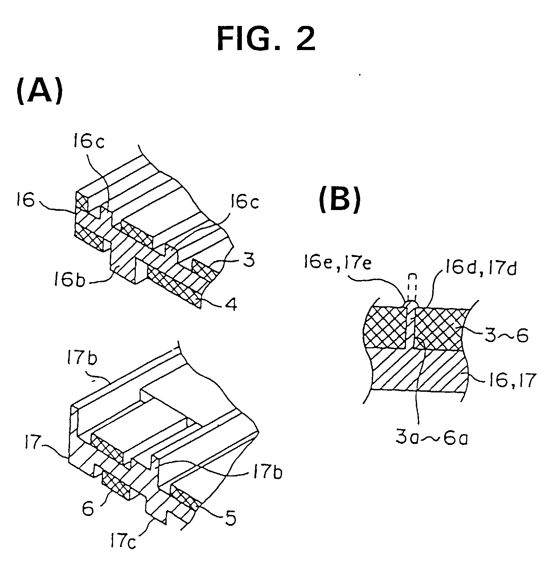

As shown in FIGS. 1 and 2, a layered element 15 is such that first and second busbars 3, 4 are arranged on or inserted in the upper and lower surfaces of an upper insulating plate 16, respectively and that third and fourth busbars 5, 6 are arranged on the upper and lower surfaces of a lower insulating plate 17. The busbars or groups of busbars 3, 4, 5 and 6 are arranged on different planes, being in particular parallel to the insulating planes.

The lower surfaces of the second busbars 4 arranged on the lower surface of the upper insulating plate 16 are opposed to and spaced apart from the third busbars 5 arranged on the upper surface of the lower insulating plate 17 by a specified distance T.

The spacing T corresponds to the thickness of the intermediate insulating plate 8 of the prior art shown in FIG. 4.

Clearance providing ribs 16b which project toward the upper surface of the lower insulating plate 17 are integrally or unitarily formed on the lower surface of the upper insulating plate 16. The ribs 16b are in contact with the upper surfaces of the third busbars 5 arranged on the upper surface of the lower insulating plate 17.

Clearance providing ribs 17a and 17b which project toward the lower surface of the upper insulating plate 16 are unitarily formed on the upper surface of the lower insulating plate 17. The rib 17a is in contact with the lower surface of the upper insulating plate 16, whereas the rib 17b is in contact with the lower surface of the second busbar 4 arranged on the lower surface of the upper insulating plate 16.

Ribs 16c which define spaces for arranging the first busbars 3 are unitarily formed on the upper surface of the upper insulating plate 16. Further, ribs 17c which define spaces for arranging the fourth busbars 6 are unitarily formed on the lower surface of the lower insulating plate 17.

The busbars 3 to 7 arranged on the upper and lower surfaces of the respective insulating plates 16, 17 are formed with narrow through holes 3a to 7a as shown in detail in FIG. 2(B). Fixing ribs 16d, 17d in the form of a narrow shaft which project from the upper and lower surfaces of the insulating plates 16, 17 are inserted through the through holes 3a to 7a. Leading ends of the fixing ribs 16d, 17d are deformed by, e.g. applying heat to melt them so that head portions 16e, 17e having a diameter larger than that of the other parts of the fixing ribs 16d, 17d are formed. In this way, the busbars 3 to 7 are secured on the insulating plates 16, 17.

The insulating plates and busbars thus fabricated are assembled as follows. First, the busbars 3 to 6 are secured on the upper and lower surfaces of the insulating plates 16, 17 in advance. Thereafter, the upper insulating plate 16 is placed over the lower insulating plate 17, bringing the lower surface of the upper insulating plate 16 into contact with the upper surface of the rib 17a of the lower insulating plate 17. In this state, the ribs 16b of the upper insulating plate 16 are in contact with the upper surfaces of the third busbars 5 arranged on the lower insulating plate 17, and the rib 17b of the lower insulating plate 17 is substantially in contact with the lower surface of the second busbar 4 arranged on the upper insulating plate 16.

As a result, the second and third busbars 4 and 5 are held between the upper and lower insulating plates 16 and 17, spaced apart by the distance T, i.e. being electrically insulated.

Accordingly, the insulating plate 8 disposed between the second and third busbars 4 and 5 of the prior art shown in FIG. 4 can be dispensed with. In other words, only two insulating plates 16, 17 are required to arrange four layers of busbars 3 to 6, i.e. the number of insulating plates can be reduced.

If N denotes the number of layers of busbars and I denotes the number of insulating plates, equations I = N - 1 and I = N/2 can be established for the prior art and the first embodiment of the invention, respectively. For example, in the case of 10 layers of busbars, 9 insulating plates are necessary for the prior art. However, according to the first embodiment of the invention, it is sufficient to prepare 5 insulating plates, i.e. the number of insulating plates can be reduced by 4.

The invention is not limited to the foregoing embodiment. The busbars and the insulating plates are not necessarily secured with each other. The insulating plates and the layers of busbars may be alternately arranged from the bottommost layer. Further, even in the case that the busbars and the insulating plates are secured with each other, a securing means is not limited to the one described in the foregoing embodiment.

A second embodiment according to the invention is shown in FIG. 1(B). In this second embodiment there are three busbars or busbar-planes or busbar-layers 4, 5 and 7 arranged between two insulating plates 16 and 17 on different planes or layers. The upper insulating plate 16 comprises clearance providing ribs or projections 16b' and 16b'' and the lower insulating plate 17 comprises clearance providing ribs 17b'. The clearance providing ribs 16b', 16b'' and 17b' of one insulating plate 16 or 17 project toward the other insulating plate 17 or 16, respectively and space or provide a clearance between the planes on which the busbars 4, 5 and 7 are arranged. The clearance providing ribs 16b', 16b'' project from the lower surface of the upper insulating plate 16 toward the lower insulating plate 17 and interacts with or holds or supports the busbar 5 being arranged on the upper surface of the lower insulating plate 17. The clearance providing rib 16b'' comprises a stepped portion or step or shoulder portion or shoulder 16b''₁ preferably near a middle portion between the upper and lower insulating plates 16, 17. A further busbar-layer or busbar 7 is arranged at and is supported on one side by the stepped portion 16b''₁. The busbars 7 are supported on their respective planes in a similar way as in the first embodiment. Thus they might be supported only by the interaction with clearance providing ribs 16b', 16b'', 17b' or additional holding means as the fixing ribs 16d, 17d might be provided.

If N denotes the number of layers of busbars and I denotes the number of insulating plates, equations I = N - 1 and I = (N + 1)/3 can be established for the prior art and the second embodiment of the invention, respectively. For example, in the case of 11 layers of busbars, 10 insulating plates are necessary for the prior art. However, according to the second embodiment of the invention, it is sufficient to prepare 4 insulating plates, i.e. the number of insulating plates can be reduced by 6. Thus according to the second embodiment the number of insulating plates can be further reduced, leading thus to an even more reduced number of components and thus simpler construction of the layer construction.

### LIST OF REFERENCE NUMERALS

- 1: Upper Casing
- 2: Lower casing
- 3 to 6: Busbar
- 7 to 9: Insulating Plate
- 15: Layered Element
- 16: Upper Insulating Plate
- 16b, 17b: Clearance Providing Rib
- 16d, 17d: Fixing Rib
- 17: Lower Insulating Plate
- 18: Busbar
- T: Spacing

## Claims

1. A busbar layer construction adapted to be accommodated in an electrical connection box, comprising at least two insulating plates (16, 17) for locating between opposing surfaces thereof at least two adjacent busbar-layers (3-7; 18), each comprising at least one busbar, wherein spacing means (16a, 16b, 17a, 17b) which are integrally formed with at least one of the insulating plates (16, 17) provide for spacing areas by keeping the opposing surfaces in a distance in a direction substantially normal to the plane of the insulating plate (16, 17) which is greater than the combined thickness of the at least two busbar-layers (3-7; 18).

2. A layer construction according to claim 1, wherein within the spacing areas the lower surfaces of busbars of one busbar-layer (4) arranged on the lower surface of the upper insulating plate (16) are opposed to and spaced apart from the upper surfaces of the busbars of the other busbar-layer (5) arranged on the upper surface of the lower insulating plate (17).

3. A layer construction according to claim 2, wherein the spacing means comprise clearance providing ribs (16b, 17a, 17b; 16b', 16b",17b') projecting from the lower surface of the upper insulating plate (16) and clearance providing ribs (16a, 17b) projecting from the upper surface of the lower insulating plate (17) in the opposing direction and are preferably in contact with opposite busbars (4, 5).

4. A layer construction according to one or more of the preceding claims, wherein spacing means (16b, 17a, 17b; 16b', 16b'', 17b') providing spacing areas are arranged on each surface of adjacent insulating plates (16, 17).

5. A layer construction according to one or more of the preceding claims, wherein at least one busbar-layer (3; 6) having at least one busbar is arranged on a surface of an insulating plate (16; 17) not facing an adjacent insulating plate (17; 16).

6. A layer construction according to one or more of the preceding claims, wherein the busbars are secured on the upper and lower surfaces of each insulating plate.

7. A layer construction according to claim 6, wherein each busbar (3-7; 18) is formed with at least one through hole (3a-7a) through which a fixing rib (16d, 17d) projecting from the corresponding insulating plate (16, 17) is insertable, respectively.

8. A layer construction according to claim 7, wherein the busbars (3-7; 18) are secured with the corresponding insulating plates (16, 17) by deforming the leading end of the fixing ribs (16d, 17d).

9. A layer construction according to one or more of the preceding claims, wherein both adjacent insulating plates (16, 17) are provided with spacing means (16b', 16b'', 17b') each projecting toward the other insulating plate (16, 17) respectively.

10. A layer construction according to one or more of the preceding claims, wherein the distance by which the insulating plates (16, 17) are spaced is greater than the combined thickness of three layers of busbars (4, 5, 18) adjacent in the above normal direction.

11. A layer construction according to one or more of the preceding claims, wherein at least one spacing area (16b") comprises a stepped portion (16b"₁).

12. A layer construction according to claim 11 and 9, wherein the stepped portion (16b"₁) supports a busbar (18) of the intermediate busbar layer, preferably approximately midway.

## Patentansprüche

1. Schienenschichtkonstruktion, geeignet zur Aufnahme in eine elektrische Anschlußdose mit zumindest zwei Isolierplatten (16, 17), um an bzw. zwischen deren gegenüberliegenden Flächen zumindest zwei angrenzende Schienenschichten (3-7; 18) mit jeweils zumindest einer Schiene anzuordnen, wobei integral mit zumindest einer der Isolierplatten (16, 17) gebildete Beabstandungsmittel (16a, 16b, 17a, 17b) ein Beabstandungsgebiet durch Halten der gegenüberliegenden Flächen in einem Abstand in einer im wesentlichen zu der Ebene der Isolierplatten (16, 17) senkrechten Richtung, der größer als die kombinierte Dicke der zumindest zwei Schienenschichten ist, bereitstellen.

2. Schichtkonstruktion gemäß Anspruch 1, wobei in den Beabstandungsgebieten die unteren Flächen der Schienen einer an der unteren Fläche der oberen Isolierplatte (16) angeordneten Schienenschicht (4) gegenüberliegend und beabstandet zu der oberen Fläche der Schienen der anderen Schienenschichten (5) angeordnet sind, die an der oberen Fläche der unteren Isolierplatte (17) angeordnet sind.

3. Schichtkonstruktion gemäß Anspruch 2, wobei die Beabstandungsmittel Freiraumbereitstellungsmittel (16b, 17a, 17b; 16b', 16b", 17b') umfassen, die von der unteren Fläche der oberen Isolierplatte (16) vorspringen und Freiraumbereitstellungsmittel (16a, 17b), die von der oberen Fläche der unteren Isolierplatte (17) in der entgegengesetzten Richtung vorspringen und vorzugsweise in Berührung mit gegenüberliegenden Schienen sind.

4. Schichtkonstruktion gemäß einem oder mehreren der vorhergehenden Ansprüche, wobei Beabstandungsgebiete bereitstellende Beabstandungsmittel (16b, 17a, 17b; 16b', 16b", 17b') an jeder Fläche der angrenzenden Isolierplatten (16, 17) angeordnet sind.

5. Schichtkonstruktion gemäß einem oder mehreren der vorhergehenden Ansprüche, wobei zumindest eine Schienenschicht (3; 6) mit zumindest einer Schiene an einer Fläche der Isolierplatte (16; 17) angeordnet ist, so daß sie nicht auf eine angrenzende Isolierplatte (17; 16) ausgerichtet ist.

6. Schichtkonstruktion gemäß einem oder mehreren der vorhergehenden Ansprüche, wobei die Schienen an der oberen und unteren Fläche jeder Isolierplatte festgelegt sind.

7. Schichtkonstruktion gemäß Anspruch 6, wobei jede Schiene (3-7; 18) mit zumindest einem Durchgangsloch (3a-7a) gebildet ist, durch welche eine sich von einer zugeordneten Isolierplatte (16, 17) erstreckende Befestigungsrippe (16d, 17d) jeweils einführbar ist.

8. Schichtkonstruktion gemäß Anspruch 7, wobei die Schienen (3-7; 18) mit den zugeordneten Isolierplatten (16, 17) durch Deformation des vorderen Endes der Befestigungsrippen (16d, 17d) festgelegt sind.

9. Schichtkonstruktion gemäß einem oder mehreren der vorhergehenden Ansprüche, wobei beide angrenzenden Isolierplatten (16, 17) mit Beabstandungsmitteln (16b', 16b", 17b') bereitgestellt sind, die jeweils in Richtung der jeweiligen anderen Isolierplatte (16; 17) vorspringen.

10. Schichtkonstruktion gemäß einem oder mehreren der vorhergehenden Ansprüche, wobei der Abstand, um welchen die Isolierplatten (16, 17) beabstandet sind, größer als die kombinierte Dicke von drei Schichten der Schienen (4, 5, 18) in der obigen senkrechter Richtung ist.

11. Schichtkonstruktion gemäß einem oder mehreren der vorhergehenden Ansprüche, wobei zumindest ein Beabstandungsgebiet (16b") einen gestuften Abschnitt (16b"₁) umfaßt.

12. Schichtkonstruktion gemäß Anpruch 11 und 9, wobei der gestufte Abschnitt (16b"₁) eine Schiene (18) der mittleren Schienenschicht hält, vorzugsweise ungefähr mittig.

## Revendications

1. Construction en couches de barres-bus adaptée pour être reçue dans un boîtier de connexion électrique, comprenant au moins deux plaques isolantes (16, 17) pour localiser entre des surfaces opposées afférentes au moins deux couches de barres-bus adjacentes (3-7 ; 18) dont chacune comprend au moins une barre-bus, dans laquelle des moyens d'espacement (16a, 16b, 17a, 17b) qui sont formés d'un seul tenant avec au moins l'une des plaques isolantes (16, 17) constituent des zones d'espacement en maintenant les surfaces opposées dans une distance suivant une direction sensiblement normale au plan de la plaque isolante (16, 17) qui est supérieure à l'épaisseur combinée des au moins deux couches de barres-bus (3-7 ; 18).

2. Construction en couches selon la revendication 1, dans laquelle, dans les zones d'espacement, les surfaces inférieures des barres-bus d'une couche de barres-bus (4) agencée sur la surface inférieure de la plaque isolante supérieure (16) sont opposées aux surfaces supérieures des barres-bus de l'autre couche de barres-bus (5) agencée sur la surface supérieure de la plaque isolante inférieure (17) et sont espacées de celles-ci.

3. Construction en couches selon la revendication 2, dans laquelle les moyens d'espacement comprennent des nervures de constitution de jeu (16b, 17a, 17b; 16b', 16b", 17b') faisant saillie depuis la surface inférieure de la plaque isolante supérieure (16) et des nervures de constitution de jeu (16a, 17b) faisant saillie depuis la surface supérieure de la plaque isolante inférieure (17) suivant la direction opposée et sont de préférence en contact avec des barres-bus opposées (4, 5).

4. Construction en couches selon une ou plusieurs des revendications précédentes, dans laquelle des moyens d'espacement (16b, 17a, 17b; 16b', 16b", 17b') constituant des zones d'espacement sont agencés sur chaque surface de plaques isolantes adjacentes (16, 17).

5. Construction en couches selon une ou plusieurs des revendications précédentes, dans laquelle au moins une couche de barres-bus (3 ; 6) comportant au moins une barre-bus est agencée sur une surface d'une plaque isolante (16 ; 17) ne faisant pas face à une plaque isolante adjacente (17 ; 16).

6. Construction en couches selon une ou plusieurs des revendications précédentes, dans laquelle les barres-bus sont fixées sur les surfaces supérieure et inférieure de chaque plaque isolante.

7. Construction en couches selon la revendication 6, dans laquelle chaque barre-bus (3-7 ; 18) est formée de manière à comporter au moins un trou traversant (3a-7a) au travers duquel une nervure de fixation (16d, 17d) faisant saillie depuis la plaque isolante correspondante (16, 17) peut être respectivement insérée.

8. Construction en couches selon la revendication 7, dans laquelle les barres-bus (3-7 ; 18) sont fixées avec les plaques isolantes correspondantes (16, 17) en déformant l'extrémité avant des nervures de fixation (16d, 17d).

9. Construction en couches selon une ou plusieurs des revendications précédentes, dans laquelle deux plaques isolantes adjacentes (16, 17) sont munies de moyens d'espacement (16b', 16b", 17b') dont chacun fait respectivement saillie en direction de l'autre plaque isolante (16, 17).

10. Construction en couches selon une ou plusieurs des revendications précédentes, dans laquelle la distance dont les plaques isolantes (16, 17) sont espacées est supérieure aux épaisseurs combinées de trois couches de barres-bus (4, 5, 18) adjacentes suivant la direction normale mentionnée ci-avant.

11. Construction en couches selon une ou plusieurs des revendications précédentes, dans laquelle au moins une zone d'espacement (16b") comprend une partie en marche (16b"₁).

12. Construction en couches selon les revendications 11 et 9, dans laquelle la partie en marche (16b"₁) supporte une barre-bus (18) de la couche de barres-bus intermédiaire, de préférence approximativement à mi-chemin.
